(19) Europäisches Patentamt
European Patent Office
Office européen des brevets

(11) **EP 2 482 976 B1**

(12) **EUROPÄISCHE PATENTSCHRIFT**

(45) Veröffentlichungstag und Bekanntmachung des Hinweises auf die Patenterteilung:
**06.05.2015 Patentblatt 2015/19**

(21) Anmeldenummer: **10742002.8**

(22) Anmeldetag: **13.08.2010**

(51) Int Cl.:
*B01J 23/755* (2006.01)  *C01B 33/04* (2006.01)
*B01J 23/26* (2006.01)  *B01J 23/70* (2006.01)
*B01J 23/75* (2006.01)  *B01J 23/78* (2006.01)
*B01J 23/86* (2006.01)  *B01J 37/02* (2006.01)
*H01L 21/02* (2006.01)

(86) Internationale Anmeldenummer:
**PCT/EP2010/061825**

(87) Internationale Veröffentlichungsnummer:
**WO 2011/038977 (07.04.2011 Gazette 2011/14)**

(54) **VERFAHREN ZUR HERSTELLUNG HÖHERER HYDRIDOSILANE**

METHOD FOR PRODUCING HIGHER HYDRIDOSILANE

PROCÉDÉ DE PRÉPARATION D'HYDRUROSILANES SUPÉRIEURS

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **02.10.2009 DE 102009048087**

(43) Veröffentlichungstag der Anmeldung:
**08.08.2012 Patentblatt 2012/32**

(73) Patentinhaber: **Evonik Degussa GmbH**
**45128 Essen (DE)**

(72) Erfinder:
• **BRAUSCH, Nicole**
**45130 Essen (DE)**
• **STOCHNIOL, Guido**
**45721 Haltern am See (DE)**
• **QUANDT, Thomas**
**45772 Marl (DE)**

(56) Entgegenhaltungen:
EP-A1- 2 135 844    JP-A- 3 183 613
US-A- 5 700 400    US-A- 6 027 705

**Beschreibung**

Die Erfindung betrifft ein Verfahren zur Herstellung höherer Hydridosilane mittels einer Dehydropolymerisationsreaktion niederer Hydridosilane, die nach dem Verfahren hergestellten höheren Hydridosilane, sowie die Verwendung der höheren Hydridosilane zur Herstellung elektronischer oder optoelektronischer Bauteilschichten und zur Herstellung siliciumhaltiger Schichten.

Hydridosilane bzw. ihre Gemische, insbesondere höhere Hydridosilane bzw. ihre Gemische, sind in der Literatur als mögliche Edukte für die Erzeugung von Siliciumschichten beschrieben. Dabei sind unter Hydridosilanen Verbindungen zu verstehen, die im Wesentlichen lediglich Silicium- und Wasserstoffatome enthalten. Hydridosilane, im Sinne der vorliegenden Erfindung sind gasförmig, flüssig oder fest und - im Falle von Feststoffen - im Wesentlichen löslich in Lösemitteln wie Toluol oder Cyclohexan oder in flüssigen Silanen wie Cyclopentasilan. Als Beispiele seien Monosilan, Disilan, Trisilan und Cyclopentasilan genannt. Höherer Hydridosilane, d.h. solche mit mindestens 2 Si-Atomen, können eine lineare, verzweigte oder (ggf. bi-/poly-)cyclische Struktur mit Si-H-Bindungen aufweisen und lassen sich durch die jeweiligen generischen Formeln $Si_nH_{2n+2}$ (linear bzw. verzweigt; mit $n \geq 2$), $Si_nH_{2n}$ (cyclisch; mit $n \geq 3$) oder $Si_nH_{2(n-i)}$ (bi- bzw. polycyclisch; $n \geq 4$; i = {Zahl der Cyclen} - 1) beschreiben.

So beschreibt z.B. EP 1 087 428 A1 Verfahren zur Herstellung von Siliciumfilmen, bei denen Hydridosilane mit mindestens drei Siliciumatomen eingesetzt werden. EP 1 284 306 A2 beschreibt u.a. Gemische enthaltend eine Hydridosilan-Verbindung mit mindestens drei Siiicium-Atomen und mindestens eine Hydridosilan-Verbindung ausgewählt aus Cyclopentasilan, Cyclohexasilan und Silylcyclopentasilan, die ebenfalls zur Herstellung von Siliciumfilmen eingesetzt werden können.

Höhere Hydridosilane können z.B. durch Dehalogenierung und Polykondensation von Halosilanen mit Alkalimetallen hergestellt werden (GB 2 077 710 A). Nachteilig bei diesem Verfahren ist jedoch, dass partiell halogenierte Silane als Verunreinigungen anfallen, die insbesondere für die Weiterverarbeitung des Produktes zu für die Halbleiterindustrie bestimmtem Silicium nachteilig sind, da sie zu Siliciumschichten mit nachteiligen Eigenschaften führen.

Andere Verfahren zur Herstellung von Hydridosilanen beruhen auf einer Dehydropolymerisationsreaktion von Hydridosilanen, bei der 1) thermisch (US 6,027,705 A für den Fall, dass kein Katalysator eingesetzt wird) und/oder 2) durch Einsatz von Katalysatoren wie a) elementaren Übergangsmetallen (heterogene Katalyse; US 6,027,705 A für den Fall, dass Platingruppen-Metalle, d.h. Ru, Rh, Pd, Os, Ir, Pt, eingesetzt werden; US 5,700,400 A für Metalle der Gruppe 3B - 7B und 8 - d.h. die Übergangsmetalle/Lanthanide ohne Cu- und Zn-Gruppe), b) Nichtmetalloxiden (heterogene Katalyse; US 6,027,705 A für den Fall, dass $Al_2O_3$ oder $SiO_2$ eingesetzt werden), c) hydridischen Cyclopentadienyl-Komplexen von Scandium, Yttrium oder seltenen Erden (homogene Katalyse; US 4,965,386 A, US 5,252,766 A), d) Übergangsmetall-Komplexen (homogene Katalyse; US 5,700,400 A für Komplexe der Metalle der Gruppe 3B - 7B und 8 - d.h. die Übergangsmetalle/Lanthanide ohne Cu- und Zn-Gruppe; JP 02-184513 A) oder e) bestimmten auf einem Träger immobilisierten Übergangsmetallen (heterogene Katalyse; US 6,027,705 A für den Fall, dass Platingruppen-Metalle auf einem Träger wie z.B. $SiO_2$ eingesetzt werden, US 5,700,400 A für auf Kohlenstoff, $SiO_2$ oder $Al_2O_3$ immobilisiertes Ruthenium, Rhodium, Palladium oder Platin) oder Übergangsmetall komplexen (heterogene Katalyse, US 6,027,705 A für den Fall, dass Platingruppen-Metallkomplexe auf einem Träger wie z.B. $SiO_2$ eingesetzt werden) aus den niederen Hydridosilanen, insbesondere $SiH_4$, unter formaler H2-Abspaltung höhere Hydridosilane gebildet werden.

Die bislang bekannten Verfahren zur Herstellung höherer Hydridosilane weisen jedoch Nachteile auf: Rein thermisch, d.h. ohne Katalysatoreinsatz durchgeführte Dehydropolymerisationsreaktionen haben den Nachteil einer hohen thermischen Belastung, die Neben- und Zersetzungsreaktionen begünstigt. Durch den Einsatz homogener Katalysatoren kann zwar das Erfordernis hoher Reaktionstemperaturen und somit die angesprochene hohe thermische Belastung vermieden werden, diese Katalysatoren haben jedoch den Nachteil, dass sie aufwändig entfernt werden müssen und darüber hinaus die Entstehung polysilinartiger Feststoffe, insbesondere in Lösemitteln und Cyclopentasilan unlöslicher $(SiH)_n$-haltiger, polymerer Feststoffe mit großen Werten für n, fördern, was zu Nachteilen bei der Aufarbeitung der Reaktionsprodukte und zu Ausbeutenverminderungen führt. Die bislang bekannten heterogenen Verfahren unter Verwendung elementarer Übergangsmetalle, reiner Nichtmetalloxide oder bestimmter auf einem Träger aufgebrachter Übergangsmetalle oder Übergangsmetallkomplexen haben weiterhin den Nachteil, dass mit ihnen keine ausreichend hohen Umsatzraten erzielt werden können.

Es ist somit die Aufgabe der vorliegenden Erfindung, die beschriebenen Nachteile des Standes der Technik zu vermeiden.

Diese Aufgaben werden erfindungsgemäß gelöst durch ein Verfahren zur Herstellung höherer Hydridosilane bei dem

- mindestens ein niederes Hydridosilan und
- mindestens ein heterogener Katalysator zur Reaktion gebracht werden, wobei der mindestens eine Katalysator
- auf einem Träger aufgebrachtes Cu, Ni, Cr und/oder Co
- und/oder auf einem Träger aufgebrachtes Oxid von Cu, Ni, Cr und/oder Co umfasst.

Wie bereits zuvor ausgeführt, sind unter höheren Hydridosilanen Verbindungen enthaltend im Wesentlichen lediglich Silicium und Wasserstoff zu verstehen, die eine lineare, verzweigte oder (ggf. bi-/poly-)cyclische Struktur mit Si-H-Bindungen aufweisen und die sich durch die jeweiligen allgemeinen Formeln $Si_nH_{2n+2}$ (linear bzw. verzweigt; mit $n \geq 2$), $Si_nH_{2n}$ (cyclisch; mit $n \geq 3$) oder $Si_nH_{2(n-i)}$ (bi- bzw. polycyclisch; $n \geq 4$; i = {Zahl der Cyclen} - 1) beschreiben lassen.

Unter niederen Hydridosilanen sind Verbindungen enthaltend lediglich Silicium und Wasserstoff zu verstehen, die eine lineare, verzweigte oder (ggf. bi-/poly-)cyclische Struktur mit Si-H-Bindungen aufweisen und die sich durch die jeweiligen allgemeinen Formeln $Si_nH_{2n+2}$ (linear bzw. verzweigt; mit $n \geq 1$), $Si_nH_{2n}$ (cyclisch; mit $n \geq 3$) oder $Si_nH_{2(n-i)}$ (bi- bzw. polycyclisch; $n \geq 4$; i = {Zahl der Cyclen} - 1) beschreiben lassen, mit der Maßgabe, dass das zahlenmittlere Molekulargewicht der eingesetzten niederen Hydridosilane kleiner ist als das der entstehenden höheren Hydridosilane.

Besonders gut geeignet ist das erfindungsgemäße Verfahren zur Herstellung höherer Hydridosilane bzw. ihrer Gemische bestehend aus bzw. im wesentlichen umfassend höhere Hydridosilane mit $2 \leq n \leq 20$. Es können aber in Abhängigkeit von der Reaktionsführung auch höhere Hydridosilane mit $n > 20$ erhalten werden. Ganz besonders geeignet ist das Verfahren zur Herstellung von Gemischen höherer Hydridosilane, die im Wesentlichen den o.g. Formeln mit $2 \leq n \leq 10$ genügen. Ein solches Gemisch enthält in der Regel $Si_2H_6$, $Si_3H_8$, $n-Si_4H_{10}$, $n-Si_5H_{12}$, $n-Si_6H_{14}$ als Hauptkomponenten, neben gegebenenfalls $n-Si_7H_{16}$, $n-Si_8H_{18}$, $n-Si_9H_{20}$ und $n-Si_{10}H_{22}$ als Nebenkomponenten. Mittel und Wege, wie das zahlenmittlere Molekulargewicht des Produkts ermittelt und das erfindungsgemäße Verfahren bei dem Erreichen eines entsprechenden zahlenmittleren Molekulargewichts gestoppt werden kann, sind dem Fachmann bekannt.

Dabei ist das erfindungsgemäße Verfahren besonders gut zur Herstellung linearer Hydridosilane geeignet. Andere, typischerweise in schlechterer Ausbeute herstellbare, Produkte / Nebenkomponenten können verzweigte Hydridosilane, wie beispielsweise $i-Si_6H_{14}$, und cyclische Hydridosilane, wie beispielsweise Cyclopentahydridosilan (cyclo-$Si_5H_{10}$), sein. In geringen Anteilen können auch bi- oder polycyclische Hydridosilane entstehen Der Anteil dieser Nebenkomponenten beträgt in Summe typischerweise maximal 10 Gew.-%, jeweils bezogen auf die Summe der Hydridosilane und der Nebenkomponenten.

Unter einem heterogenen Katalysator ist vorliegend ein Katalysator zu verstehen, der in einer anderen Phase vorliegt als die Reaktanden. Unter dem bei dem erfindungsgemäßen Verfahren eingesetzten Katalysator, der auf einem Träger aufgebrachtes Metall oder Metall-Oxid umfasst, ist ein Katalysator zu verstehen, der auf oder vermengt mit einem für diese chemische Reaktion für sich genommen inerten bzw. (verglichen mit dem Katalysatormaterial) weniger aktiven Stoff (dem "Träger") im Wesentlichen auf der Oberfläche des Trägermaterials durch Beschichten, Fällen, Imprägnieren oder Mischen aufgebrachtes heterogenes Katalysatormaterial aufweist. Das Katalysatormaterial kann dabei elementar bzw. in Verbindung auf dem Träger und/oder unter atomarer Einbindung in die Kristall- oder Schichtstruktur des Trägermaterials vorliegen. Das bei dem erfindungsgemäßen Verfahren eingesetzte heterogene Katalysatormaterial umfasst Kupfer, Nickel, Chrom und/oder Kobalt, das 1) aufgebracht auf dem jeweiligen Träger, d.h. als elementares Metall auf dem Träger und/oder unter atomarer Einbindung in die Kristall- oder Schichtstruktur des Trägermaterials, und/oder 2) auf dem Träger aufgebrachtes Oxid, d.h. a) als Metalloxid einer definierten Oxidationsstufe, b) als gemischtvalente Verbindung verschieden valenter Oxide oder c) mindestens eines Oxids in Kombination mit dem elementaren Metall, das bzw. die jeweils als chemische Verbindung(en) auf dem Träger und/oder unter Einbindung in die Kristall- oder Schichtstruktur des Trägermaterials vorliegen kann bzw. können.

Bevorzugt einsetzbare niedere Hydridosilanen, die den Vorteil bieten, leicht zugänglich zu sein, sind die Verbindungen Monosilan, Disilan und Trisilan. Aufgrund ihrer Gasförmigkeit bei Raumtemperatur und der daraus resultierenden Möglichkeit, sie als Gase zu handhaben, werden Monosilan und Disilan besonders bevorzugt. Ganz besonders bevorzugt ist ein Gemisch von Monosilan und Disilan, das zu besonders guten Ausbeuten führt.

Als Träger bevorzugt werden großoberflächige Stoffe, insbesondere Aktivkohle, Aluminiumoxid (insbesondere Tonerde), Siliciumdioxid, Kieselgel, Silicate, Kieselgur, Talk, Kaolin, Ton, Titandioxid, Zirkonoxid und Zeolithe, da diese zugleich als Promotoren für die "aufgezogenen" Katalysatoren wirken und somit die Reaktionsraten weiter erhöhen können. Besonders gute Reaktionsraten können mit Aluminiumoxid als Träger erzielt werden.

Der mindestens eine heterogene Katalysator, insbesondere das heterogene Katalysatormaterial, das auf den Träger aufgebracht ist, umfasst bevorzugt zur Erzielung besonders guter Ausbeuten neben den genannten Metallen Kupfer, Nickel, Chrom oder Kobalt keine weiteren Übergangsmetalle, Lanthanoide oder Actinoide in elementarer Form oder als Verbindungen.

Ein bevorzugt einsetzbarer Katalysator ist herstellbar durch 1) Imprägnieren des Trägers mit einer wässrigen Lösung eines Salzes von Kupfer, Nickel, Chrom und/oder Kobalt, 2) Trocknung, und 3) Calcinierung, wobei sowohl Imprägnierung, Trocknung als auch Calcinierung ggf. auch unter reduzierenden oder oxidierenden Bedingungen durchgeführt werden können. Dabei können Katalysatoren umfassend auf einem Träger aufgebrachtes Cu, Ni, Cr oder Co besonders gut unter Wahl reduzierender Bedingungen hergestellt werden, wohingegen Katalysatoren umfassend auf einem Träger aufgebrachtes Oxid von Cu, Ni, Cr oder Co besonders gut unter Wahl oxidierender Bedingungen herstellbar sind. Vor einer Reduktion können die Metallsalzverbindungen, insbesondere Nitrate, weiterhin zunächst in die oxidische Form umgewandelt werden. Bevorzugt erfolgt dabei die Trocknung bei Temperaturen von 80 - 150 °C. Die Calcinierung erfolgt bevorzugt bei Temperaturen von 300 - 600 °C. Die Reduktion erfolgt bevorzugt bei Temperaturen von 150 °C - 500 °C.

Der Gewichtsprozent-Anteil des auf dem Träger aufgebrachten Cu, Ni, Cr oder Co bzw. des Oxids von Cu, Ni, Cr oder Co beträgt vorzugsweise zwischen 0,5 und 65 Gew.-% bezogen auf die Gesamtmasse des Katalysators (Träger + Katalysatormaterial). Dieser Gewichtsprozentanteil kann dabei durch Aufbringen bekannt konzentrierter Lösungen auf einen calcinierten Träger und Wiegen nach erfolgter Trocknung und zweiter Calcinierung (gegebenenfalls unter reduzierenden bzw. oxidierenden Bedingungen und unter der Annahme, dass dabei kein Metall verloren geht) bestimmt werden.

Wird die Reaktion in der flüssigen Phase im Batchbetrieb durchgeführt; beträgt der Anteil des Katalysators bevorzugt 0,001 - 0,5, besonders bevorzugt 0,01 - 0,1, ganz besonders bevorzugt 0,02 - 0,06 Gew.-% bezogen auf die Masse der flüssigen Phase.

Wird die Reaktion kontinuierlich in der Gasphase durchgeführt, beträgt die GHSV (gas hourly space velocity), die definiert ist als GHSV = durchströmtes Gasvolumen bei STP-Bedingungen pro h / Katalysatorvolumen, bevorzugt $0,1 - 4000 \ h^{-1}$, besonders bevorzugt $1 - 3000 \ h^{-1}$, ganz besonders bevorzugt $10 - 1000 \ h^{-1}$.

Die Temperatur, bei der das erfindungsgemäße Verfahren durchgeführt wird, ist nicht kritisch. Das erfindungsgemäße Verfahren zur Herstellung höherer Hydridosilane wird jedoch vorzugsweise bei Temperaturen von 0 - 400 °C durchgeführt. Bevorzugt wird es bei Temperaturen von 35 - 170 °C, ganz besonders bevorzugt bei Temperaturen von 140 - 160 °C durchgeführt.

Bevorzugt werden dabei weiterhin absolute Drücke von 1 - 200 bar, besondersbevorzugt 10 - 160 bar, ganz besonders bevorzugt 50 - 150 bar, eingesetzt. Unterhalb von 1 bar sind die Umsätze oft nicht zufriedenstellend, und oberhalb von 200 bar absolut rechtfertigen die materialtechnischen Anforderungen den Aufwand nicht.

Die Reaktionszeit kann wenige Stunden bis mehrere Tagen betragen. Der Anteil höherer Silane nimmt dabei mit der Reaktionszeit zu.

Dabei kann es Vorteile haben, die im Reaktionsgemisch zwischenzeitlich entstehenden gewünschten höheren Silane abzutrennen und die eingesetzten oder ggf. im Reaktionsverlauf entstehenden niederen Silane, insbesondere eingesetztes oder entstehendes Disilan in dem Fall, dass Silane mit mindestens 3 Siliciumatomen als Produkte gewünscht werden, der Reaktion wieder zuzuführen.

Das erfindungsgemäße Verfahren weiterhin kann in An- oder Abwesenheit eines Lösemittels durchgeführt werden. Vorzugsweise wird es jedoch in Gegenwart eines Lösemittels durchgeführt. Geeignet sind prinzipiell alle Lösungsmittel, die weder mit den Einsatzstoffen noch mit den Produkten reagieren. Bevorzugt einsetzbar sind lineare, verzweigte und cyclische aliphatische und substituierte oder unsubstituierte aromatische Kohlenwasserstoffe (insbesondere cyclische Alkane, Benzol und Toluol), Ether (insbesondere Dialkylether, Furane oder Dioxane), sowie Dimethylformamid, Ethylacetat oder Butylacetat.

Das erfindungsgemäße Verfahren kann in An- oder Abwesenheit von den Reaktionsverlauf unterstützenden Gasen durchgeführt werden. So können z.B. selbst nicht reaktive Gase, insbesondere Stickstoff, Argon oder Helium, zum Verdünnen des Reaktionsgemisches eingesetzt werden. Weiterhin kann zur Unterstützung des Reaktionsverlaufs, insbesondere zur Vermeidung von Rückreaktionen, entstehender Wasserstoff abgeführt werden.

Es kann jedoch auch Vorteile haben, nicht nur den entstehenden Wasserstoff nicht zu entfernen, sondern bei der Reaktion sogar mit Wasserstoff zu beaufschlagen: Dies kann zwar zu Verminderungen der Reaktionsgeschwindigkeit führen, vermindert aber die Bildung höhermolekularer Feststoffe. Dabei ist der Anteil an Wasserstoff zunächst nicht limitiert. Er richtet sich nach den Einsatzstoffen (niedere Hydridosilane und Katalysator) sowie den Reaktionsbedingungen (Druck und Temperatur). Der Partialdruck des Wasserstoffes beträgt vorzugsweise 1-200% des Druckes der eingesetzten Hydridosilane, wenn gasförmige Silane eingesetzt werden. In der Regel wird der Anteil an Wasserstoff so gewählt, dass der Partialdruck des Wasserstoffes wenigstens 5% des Gesamtdruckes entspricht. Bevorzugt ist ein Bereich von 5% bis 80%, besonders bevorzugt ein Bereich von 5% bis 50%.

Sollten bei der Reaktion für die weiteren Einsatzzwecke nachteilige höhermolekulare Nebenkomponenten (insbesondere höhere Hydridosilane mit mehr als 20 Si-Atomen) angefallen sein, können diese über dem Fachmann bekannte Verfahren, insbesondere über Destillation oder über den Einsatz adsorptiver Verfahren, entfernt werden. Möglich ist auch eine Aufreinigung unter Einsatz eines Querstrom-Membranverfahrens mit mindestens einem Membrantrennschritt unter Verwendung einer Permeationsmembran.

Gegenstand der Erfindung sind auch die nach dem erfindungsgemäßen Verfahren hergestellten höheren Hydridopolysilane bzw. ihre Gemische.

Diese erfindungsgemäß hergestellten höheren Hydridopolysilane bzw. ihre Gemische eignen sich für eine Vielzahl von Verwendungen. Besonders gut eignen sie sich zur Herstellung elektronischer oder optoelektronischer Bauteilschichten. Gegenstand der Erfindung ist somit auch die Verwendung der nach dem erfindungsgemäßen Verfahren erhältlichen höheren Hydridosilane zur Erzeugung optoelektronischer oder elektronischer Bauteilschichten. Bevorzugt eignen sich die nach dem erfindungsgemäßen Verfahren erhältlichen höheren Hydridosilane zur Herstellung ladungstransportierender Komponenten in optoelektronischen oder elektronischen Bauteilen. Die nach dem erfindungsgemäßen Verfahren erhältlichen höheren Hydridosilane eignen sich weiterhin zur Herstellung siliciumhaltiger Schichten, vorzugsweise elementarer Siliciumschichten.

Im folgenden wird nun exemplarisch ein typischer Reaktionsverlauf beschrieben: Zum Einsatz kommen vorzugsweise Edelstahlreaktoren, die mit einem Glasliner, einem Thermoelement, einem Druckaufnehmer, einer Flüssigprobennahme, einer Zu- und einer Abführung für die Edukte als Gase oder Flüssigkeiten sowie einem Katalysatorkorb ausgestattet sind. Nach Befüllung des Reaktorkorbes mit dem Katalysator werden die Katalysatoren mehrfach inertisiert und anschließend mit Lösemittel befüllt. Über die Gaszuleitungen wird der Reaktor mit den Edukten beaufschlagt. Im Anschluss wird der Reaktor auf die gewünschte Temperatur geheizt und die Reaktion durch Starten des Rührers gestartet.

Die Reaktionszeiten hängen naturgemäß von den gewählten Edukten und Reaktionsparametern ab. Typischerweise betragen die Reaktionsdauern bei Reaktionstemperaturen von 40 °C und Drücken von 60 bar ca. 1 - 24 Stunden.

Das entstehende Produktgemisch bestehend aus den gebildeten höheren Hydridosilanen, ggf. Lösungsmittel und ggf. nicht umgesetzten Edukten kann nach Entfernung des Katalysatorkorbes zur Anwendung im Halbleiter- bzw. Photovoltaikbereich zum Einsatz kommen, da bei gegebener Reinheit der Einsatzstoffe keine Verunreinigung von störenden Nebenkomponenten zu erwarten sind.

Sollten bei der Reaktion für die weiteren Einsatzzwecke störende höhermolekulare Nebenkomponenten (insbesondere höhere Hydridosilane mit mehr als 20 Si-Atomen) angefallen sein, können diese vor dem Einsatz des Reaktionsprodukts über dem Fachmann bekannte Verfahren, insbesondere über Destillation oder über den Einsatz adsorptiver Verfahren, abgetrennt werden. Möglich ist auch eine Aufreinigung unter Einsatz eines Querstrom-Membranverfahrens mit mindestens einem Membrantrennschritt unter Verwendung einer Permeationsmembran.

Die nachfolgenden Beispiele erläutern den Gegenstand der vorliegenden Erfindung, ohne ihn zu beschränken.

**Beispiele**

Ein mit einem Glasliner, einem Thermoelement, einem Druckaufnahme, einer Flüssigprobennahme, einer Gaszu- und Gasabführung und einem Katalysatorkorb ausgestatteter Edelstahl-Reaktor (MRS 500 ParrInstruments) wird mit dem jeweiligen heterogenen Katalysator in der Menge gemäß unten aufgeführter Tabelle 1 befüllt (Katalysatorkorb). Danach wird der Reaktor dreimal inertisiert (Argon und Vakuum im Wechsel) und mit 30 ml getrocknetem Toluol befüllt.

Über die Gaszuleitung wird der Reaktor (Innenvolumen 70 ml) bei Raumtemperatur mit 60 bar $SiH_4$ beaufschlagt und auf die jeweils angegebene Temperatur geheizt. Durch Starten des Rührers (700 U/min) wird die Reaktion gestartet. Nach einer Reaktionszeit von 20 h erfolgt eine Flüssigprobennahme. Die entnommene Flüssigkeit wird gaschromatographisch untersucht.

Die Auswertung der Proben erfolgte nach der Methode des internen Standards (in diesem Fall Heptan) Die angegebene Produktmenge entspricht der Summe an detektierten Silanen.

k wurde bestimmt zwischen Cyclopentasilan und Heptan.

$$m(x) = \frac{F(x) \times m(St)}{F(St)} \times k \qquad\qquad Summe = \sum_{x=2}^{x=max} Si_x$$

Tabelle 1

| Nr. | Katalysator | Einwaage (g) | (SiH₄)-Druck (bar) | Lösemittel | t (h) | T (°C) | Produkt menge | T (°C) | Produkt menge |
|---|---|---|---|---|---|---|---|---|---|
| 1 | 14,3 %[1] Co/Al$_2$O$_3$ | 0,5 | 60 | Toluol | 20 | 40 | 0,015 | 150 | 0,02 |
| 2 | 20 % NiO, 73 % Alumosilikat, 7 % Al$_2$O$_3$ | 0,4 | 60 | Toluol | 20 | 40 | 0,004 | 150 | 0,013 |
| 3 | 9,4 % Cu, 4,2 % Ni, 0,84 % Cr / Al$_2$O$_3$ | 0,4 | 60 | Toluol | 20 | 40 | 0,041 | 150 | 0,043 |
| 4 | 9,1 % Cu, 6,1 % Ni / Al$_2$O$_3$ | 0,5 | 60 | Toluol | 20 | 40 | 0,038 | 150 | 0,052 |
| 5 | 7,3 % Cu, 3,3 % Ni, 6,6 % Cr / Al$_2$O$_3$ | 0,6 | 60 | Toluol | 20 | 40 | 0,014 | 150 | 0,032 |
| 9 | 18,2 % Ni, 0,23 % Ba / Al$_2$O$_3$ | 0,5 | 60 | Toluol | 20 | 40 | 0,045 | 150 | 0,053 |
| 10 | 5,3 % oxidisches Ni (über ammoniakalische Ni-Salzlösung) auf Al$_2$O$_3$-Träger, calciniert 10 h bei 600 °C | 0,4 | 60 | Toluol | 20 | 40 | 0,042 | 150 | 0,046 |
| 11 | 5,3 % oxidisches Ni (über Ni-Nitratlösung) auf Al$_2$O$_3$-Träger, calciniert 10 h bei 450 °C | 0,4 | 60 | Toluol | 20 | 40 | 0,026 | 150 | 0,062 |
| 12 | 5,3 % oxidisches Ni (über ammoniakalische Ni-Salzlösung) auf Al$_2$O$_3$-Träger, calciniert 10 h bei 450 °C | 0,4 | 60 | Toluol | 20 | 40 | 0,021 | 150 | 0,04 |
| 13 | 1 % oxidisches Ni (über ammoniakalische Ni-Salzlösung) auf Al$_2$O$_3$-Träger, calciniert 10 h bei 450 °C | 0,4 | 60 | Toluol | 20 | 40 | 0,05 | | |
| 14 | 10,3 % oxidisches Ni (über ammoniakalische Ni-Salzlösung) auf Al$_2$O$_3$-Träger, calciniert 10 h bei 450 °C | 0,4 | 60 | Toluol | 20 | 40 | 0,023 | 150 | 0,064 |
| **Vergleichsbeispiele** | | | | | | | | | |
| 15 | 0,5 % Pd / Al$_2$O$_3$ | 0,4-0,7 | 60 | Toluol | 20 | 40 | 0 | 150 | 0,001 |
| 16 | 5 % Pt / C | 0,3 | 60 | Toluol | 20 | 40 | 0 | 150 | 0,001 |
| 17 | 1 % Ru / Al$_2$O$_3$ | 0,6-0,7 | 60 | Toluol | 20 | 40 | 0 | 150 | 0,001 |
| 18 | 1 % Ru / TiO$_2$ | 0,7 | 60 | Toluol | 20 | 40 | 0,001 | 150 | 0,002 |
| 19 | SiO$_2$ (Aerolyst 3041, Evonik Degussa GmbH) | 0,4 | 60 | Toluol | 20 | 40 | 0 | 150 | |
| 20 | Al$_2$O$_3$ (Spheralite, Axens) | 0,3 | 60 | Toluol | 20 | 40 | 0 | 150 | |

[1] Hier und im folgenden bestimmt als Gewichtsprozent Metall bzw. Metalloxid bezogen auf.die Gesamtmasse des Träger durch Aufbringen bekannt konzentrierter Lösungen auf einen calcinierten Träger und Wiegen nach erfolgter Trocknung und zweiter Calcinierung (gegebenenfalls unter reduzierenden bzw. oxidierenden Bedingungen und unter der Annahme, dass dabei kein Metall verloren geht)

**Patentansprüche**

1. Verfahren zur Herstellung höherer Hydridosilane bei dem

   - mindestens ein niederes Hydridosilan und
   - mindestens ein heterogener Katalysator zur Reaktion gebracht werden,
   **dadurch gekennzeichnet, dass**
   der mindestens eine Katalysator
   - auf einem Träger aufgebrachtes Cu, Ni, Cr und/oder Co
   - und/oder auf einem Träger aufgebrachtes Oxid von Cu, Ni, Cr und/oder Co umfasst.

2. Verfahren nach Anspruch 1,
   **dadurch gekennzeichnet, dass**
   das mindestens eine niedere Hydridosilan ausgewählt wird aus der Gruppe bestehend aus Monosilan, Disilan und Trisilan.

3. Verfahren nach Anspruch 2,
   **dadurch gekennzeichnet, dass**
   als mindestens ein niederes Hydridosilan ein Gemisch von Monosilan und Disilan eingesetzt wird.

4. Verfahren nach einem der vorhergehenden Ansprüche,
   **dadurch gekennzeichnet, dass**
   der Träger aus mindestens einem Stoff ausgewählt aus der Gruppe bestehend aus Aktivkohle, Aluminiumoxid, Siliciumdioxid, Kieselgel, Silicate, Kieselgur, Talk, Kaolin, Ton, Titandioxid, Zirkonoxid und Zeolithen besteht.

5. Verfahren nach einem der vorhergehenden Ansprüche,
   **dadurch gekennzeichnet, dass**
   der mindestens eine Katalysator neben den genannten Metallen Kupfer, Nickel, Chrom oder Kobalt keine weiteren Übergangsmetalle, Lanthanoide oder Actinoide in elementarer Form oder als Verbindungen umfasst.

6. Verfahren nach einem der vorhergehenden Ansprüche,
   **dadurch gekennzeichnet, dass**
   der heterogene Katalysator herstellbar ist durch 1) Imprägnieren des Trägers mit einer wässrigen Lösung eines Salzes von Kupfer, Nickel, Chrom und/oder Kobalt, 2) Trocknung, und 3) Calcinierung.

7. Verfahren nach einem der vorhergehenden Ansprüche,
   **dadurch gekennzeichnet, dass**
   der Gewichtsprozent-Anteil des auf dem Träger aufgebrachten Cu, Ni, Cr oder Co bzw. dessen Oxids zwischen 0,5 und 65 Gew.-%, bezogen auf die Gesamtmasse des Trägers, beträgt.

8. Verfahren nach einem der vorhergehenden Ansprüche,
   **dadurch gekennzeichnet, dass**
   das mindestens eine niedere Hydridosilan und der mindestens eine heterogene Katalysator in Gegenwart eines Lösemittels zur Reaktion gebracht werden.

**Claims**

1. A process for preparing higher hydridosilanes, in which

   - at least one lower hydridosilane and
   - at least one heterogeneous catalyst are reacted,
   **characterized in that**
   the at least one catalyst comprises
   - Cu, Ni, Cr and/or Co applied to a support
   - and/or oxide of Cu, Ni, Cr and/or Co applied to a support.

2. A process according to claim 1,

**characterized in that**
the at least one lower hydridosilane is selected from the group consisting of monosilane, disilane and trisilane.

3. A process according to claim 2,
   **characterized in that**
   the at least one lower hydridosilane used is a mixture of monosilane and disilane.

4. A process according to any one of the preceding claims,
   **characterized in that**
   the support comprises at least one substance selected from the group consisting of activated carbon, aluminium oxide, silicon dioxide, silica gel, silicates, kieselguhr, talc, kaolin, clay, titanium dioxide, zirconium oxide and zeolites.

5. A process according to any one of the preceding claims,
   **characterized in that**
   the at least one catalyst, apart from the copper, nickel, chromium or cobalt metals mentioned, does not comprise any further transition metals, lanthanoids or actinoids in elemental form or as compounds.

6. A process according to any one of the preceding claims,
   **characterized in that**
   the heterogeneous catalyst is preparable by 1) impregnating the support with an aqueous solution of a salt of copper, nickel, chromium and/or cobalt, 2) drying, and 3) calcining.

7. A process according to any one of the preceding claims,
   **characterized in that**
   the percentage by weight of the Cu, Ni, Cr or Co, or oxide thereof, applied to the support is in the range from 0.5 to 65% by weight, based on the total mass of the support.

8. A process according to any one of the preceding claims,
   **characterized in that**
   the at least one lower hydridosilane and the at least one heterogeneous catalyst are reacted in the presence of a solvent.


## Revendications

1. Procédé pour la préparation d'hydridosilanes supérieurs, dans lequel on fait réagir

   - au moins un hydridosilane inférieur et
   - au moins un catalyseur hétérogène,
   **caractérisé en ce que** ledit au moins un catalyseur comprend
   - Cu, Ni, Cr et/ou Co appliqué sur un support et/ou
   - un oxyde de Cu, Ni, Cr et/ou Co appliqué sur un support.

2. Procédé selon la revendication 1, **caractérisé en ce que** ledit au moins un hydridosilane inférieur est choisi dans le groupe constitué par monosilane, disilane et trisilane.

3. Procédé selon la revendication 2, **caractérisé en ce qu'**on utilise, comme ledit au moins un hydridosilane inférieur, un mélange de monosilane et de disilane.

4. Procédé selon l'une quelconque des revendications précédentes, **caractérisé en ce que** le support est constitué par au moins une substance choisie dans le groupe constitué par le charbon actif, l'oxyde d'aluminium, le dioxyde de silicium, le gel silicique, les silicates, les terres de diatomées, le talc, le kaolin, l'argile, le dioxyde de titane, l'oxyde de zirconium et les zéolithes.

5. Procédé selon l'une quelconque des revendications précédentes, **caractérisé en ce que** ledit au moins un catalyseur ne comprend, outre les métaux mentionnés cuivre, nickel, chrome ou cobalt, pas d'autres métaux de transition, de lanthanides ni d'actinides sous forme élémentaire ou sous forme de composés.

**6.** Procédé selon l'une quelconque des revendications précédentes, **caractérisé en ce que** le catalyseur hétérogène peut être préparé par 1) imprégnation du support par une solution aqueuse d'un sel de cuivre, de nickel, de chrome et/ou de cobalt, 2) séchage et 3) calcination.

**7.** Procédé selon l'une quelconque des revendications précédentes, **caractérisé en ce que** la proportion en pourcentage en poids de Cu, de Ni, de Cr ou de Co ou de leur oxyde appliqué sur le support est comprise entre 0,5 et 65% en poids, par rapport à la masse totale du support.

**8.** Procédé selon l'une quelconque des revendications précédentes, **caractérisé en ce qu'**on fait réagir ledit au moins un hydridosilane inférieur et ledit au moins un catalyseur hétérogène en présence d'un solvant.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1087428 A1
- EP 1284306 A2
- GB 2077710 A
- US 6027705 A
- US 5700400 A
- US 4965386 A
- US 5252766 A
- JP 2184513 A